# FASCICULE DE BREVET EUROPEEN

(11) **EP 2 394 309 B1**
(45) Date de publication et mention de la délivrance du brevet: **17.04.2013**
(21) Numéro de dépôt: 10708276.0
(22) Date de dépôt: 04.02.2010
(51) Int. Cl.: B64D 41/00, F02K 1/82, H01L 35/30

(54) **GENERATION THERMOELECTRIQUE POUR TURBINE A GAZ**
THERMOELEKTRISCHE ERZEUGUNG FÜR EINE GASTURBINE
THERMOELECTRIC GENERATION FOR A GAS TURBINE

(30) Priorité: 06.02.2009 FR 0950739
(43) Date de publication de la demande: 14.12.2011
(73) Titulaire: Turbomeca, 64510 Bordes (FR)
(72) Inventeur: BRILLET, Christophe, F-64290 Gan (FR)
(74) Mandataire: Calvo de Nó, Rodrigo
(86) Numéro de dépôt international: PCT/FR2010/050176
(87) Numéro de publication internationale: WO 2010/089505

(56) Documents cités:
- WO-A-01/61768
- WO-A-2008/139096
- DE-A1- 19 946 806
- DE-A1-102007 036 930
- FR-A- 1 504 078
- JP-A- 2001 263 088
- US-A1- 2009 159 110
- DATABASE WPI Week 200417 Thomson Scientific, London, GB; AN 2004-170126 XP002564715 -& CZ 20 021 405 A3 (NEDBAL M) 17 décembre 2003 (2003-12-17)

## Description

La présente invention a pour objet un dispositif de production de puissance électrique pour une turbine à gaz d'aéronef ou analogues.

Les aéronefs consomment pour leurs équipements internes une quantité d'électricité non négligeable. Cette puissance électrique est en générale produite par un alternateur prélevant de la puissance mécanique à la turbine à gaz. Il est donc intéressant de disposer de moyens de production de puissance électrique qui n'entraînent pas d'augmentation de la consommation en carburant de l'aéronef.

Par ailleurs, on connaît des cellules thermoélectriques capables de produire une puissance électrique sous l'effet d'un différentiel de température qui leur est appliqué.

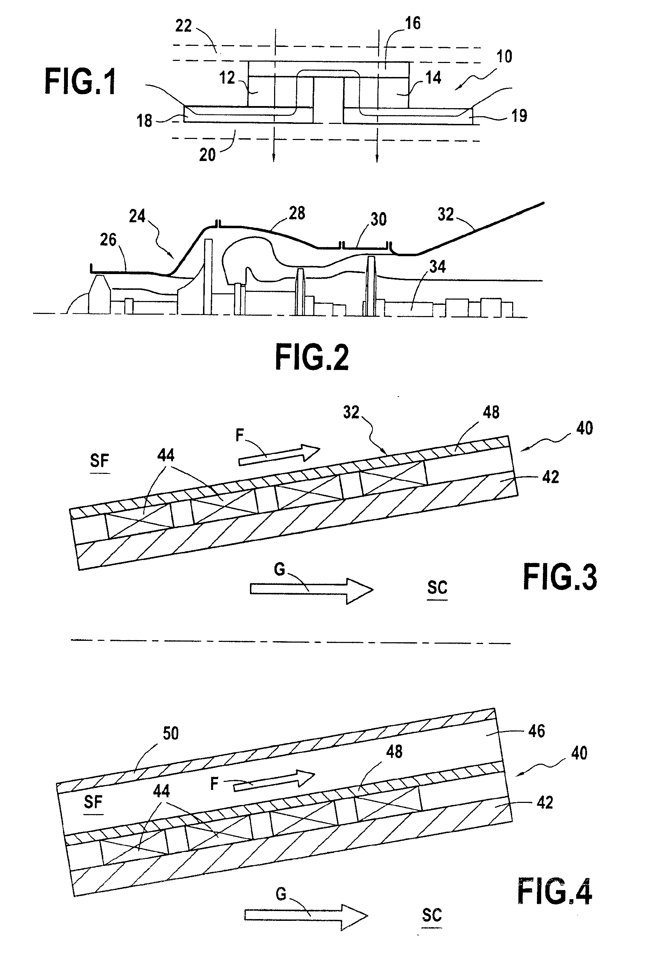

On a représenté sur la figure 1 annexée une telle cellule thermoélectrique 10. Elle est constituée essentiellement par une jonction semi-conductrice constituée par deux éléments 12 et 14 respectivement dopés de type N et de type P. Ces deux éléments sont reliés entre eux par un conducteur électrique 16 et il comporte deux connexions électriques formant les bornes 18 et 19. Le plus souvent, cet ensemble constituant la cellule unitaire thermoélectrique est monté entre deux supports électriquement isolants tels que par exemple 20 et 22 qui facilitent la fixation d'une telle cellule sur un autre composant. Plusieurs cellules élémentaires peuvent bien sûr être associées entre elles.

Il est par ailleurs bien connu que l'efficacité ou le rendement de telles cellules est directement proportionnelle à l'écart de température qui existe entre les deux faces de cette cellule constituée par exemple par les supports isolants 20 et 22.

Dans la demande de brevet PCT WO 2005/017331, on décrit un générateur de puissance thermoélectrique pour un moteur utilisant une turbine à gaz notamment pour la propulsion d'aéronefs.

Dans cette demande de brevet, on propose de disposer autour d'une zone chaude des ensembles de cellules thermoélectriques en forme d'anneaux, sans qu'il soit précisé les conditions de montage de ces ensembles de cellules thermoélectriques.

Dans la demande de brevet PCT WO 01/61768, on décrit un dispositif de production de puissance électrique dans une turbine à gaz ou analogues d'un aéronef comprenant une pluralité de cellules thermoélectriques dont une face entoure une source chaude , dans lequel la source froide est constituée par une circulation d'un fluide froid réalisée sur l'autre face desdits cellules thermoélectriques.

Or, comme on l'a expliqué précédemment, le rendement d'un tel équipement de production de puissance électrique dépend très directement de la différence de température entre la source chaude et la source froide entre lesquelles sont interposées les cellules thermoélectriques.

Un objet de la présente invention est de fournir un dispositif de production de puissance électrique pour une turbine à gaz d'aéronef ou analogues qui permette d'obtenir un rendement des cellules thermoélectriques sensiblement amélioré sans augmenter significativement la consommation en carburant de l'aéronef.

Pour atteindre ce but selon l'invention, le dispositif de production de puissance électrique dans une turbine à gaz ou analogues d'un aéronef comprend une pluralité de cellules thermoélectriques dont une face entoure une source chaude, et il se caractérise en ce que la source froide est constituée par une circulation d'un fluide froid réalisée sur l'autre face desdits cellules thermoélectriques, selon la revendication 1.

On comprend que dans ce mode de réalisation, c'est la circulation de fluide froid qui constitue la source froide appliquée aux cellules thermoélectriques, ce qui améliore le rendement énergétique de celles-ci.

Selon un premier mode préféré de mise en oeuvre, le système de production de puissance électrique est caractérisé en ce que ledit fluide froid est choisi dans le groupe comprenant le carburant de ladite turbine, l'huile de refroidissement ou de lubrification, l'air prélevé au niveau des compresseurs de ladite turbine, l'air de refroidissement du compartiment moteur et l'air extérieur à ladite turbine.

On comprend que l'utilisation des fluides énoncée ci-dessus et en particulier celle de l'huile de refroidissement ou du carburant procure une capacité de refroidissement élevée tout en n'entraînant sensiblement aucune consommation supplémentaire puisque bien entendu aussi bien le carburant que l'huile de refroidissement sont recyclés.

Selon un premier mode de mise en oeuvre, la source chaude est constituée par la paroi de la tuyère de la turbine réchauffée par convection par les gaz d'échappement.

Selon l'invention le système est caractérisé en ce que ladite source froide est constituée par au moins une zone annulaire dans laquelle est introduit ledit fluide froid. La paroi interne de ladite zone annulaire est en contact avec le support 20 desdites cellules thermoélectriques. La paroi externe de ladite zone annulaire étant l'enveloppe extérieure est refroidie par convection par le fluide froid.

Le dispositif est caractérisé en une alternance de zones annulaires concentriques dans lesquelles circulent alternativement la source froide et les gaz d'échappement. Entre chaque zone annulaire sont placées des cellules thermoélectriques.

On comprend que grâce à la présence de ces zones annulaires entre lesquelles s'intercalent des cellules thermoélectriques on réalise un échangeur thermique à contre-courant améliorant ainsi nettement le rendement global du dispositif de production de puissance électrique.

Plus précisément, la source chaude est constituée par au moins une zone annulaire dans laquelle s'écoule une partie des gaz d'échappement (constituant le fluide chaud) selon un mouvement en spirale vers les rayons extérieurs ; et par au moins une zone annulaire dans laquelle s'écoule le fluide froid selon un mouvement en spirale vers les rayons intérieurs. Au moins un ensemble annulaire de cellules thermoélectriques est monté concentriquement de telles sorte à ce que l'une des faces de cet ensemble soit en contact avec le fluide froid et l'autre face soit en contact avec le fluide chaud, par quoi on réalise ainsi un échangeur cylindrique à contre-courant.

La présente invention porte aussi sur l'utilisation du dispositif de production de puissance électrique selon l'invention pour l'alimentation d'accessoires de la turbine à gaz en électricité, comme par exemple le FADEC (régulateur électronique) ou des pompes entraînées par des moteurs électriques.

La présente invention porte enfin sur un turbomoteur d'hélicoptère comportant un dispositif de production de puissance électrique selon l'invention. De préférence, les cellules thermoélectriques dudit dispositif sont montées sur une tuyère d'échappement du turbomoteur.

D'autres caractéristiques et avantages de l'invention apparaîtront mieux à la lecture de la description qui suit de plusieurs modes de réalisation de l'invention donnés à titre d'exemples non limitatifs. La description se réfère aux figures annexées, sur lesquelles :
- la figure 1 déjà décrite montre un mode possible de réalisation de cellules thermoélectriques utilisables dans l'invention ;
- la figure 2 est une demi-vue en coupe longitudinale d'une turbine à gaz pour aéronefs susceptible d'être équipée avec le dispositif de production de puissance électrique ;
- la figure 3 montre un premier mode de mise en oeuvre du dispositif de production de puissance électrique ;
- la figure 4 montre une première variante de mise en oeuvre du dispositif de production de puissance électrique ;
- la figure 5A montre en perspective une tuyère de turbine à gaz d'aéronef équipée d'échangeur de chaleur pour améliorer le rendement global du dispositif de production de puissance électrique ;
- la figure 5B est une vue d'extrémité de la tuyère équipée des échangeurs de chaleur selon la flèche VB de la figure 5A ; et
- la figure 6 montre de façon schématique un exemple de prélèvement de carburant pour constituer la source froide.

La figure 2 montre de façon simplifiée un exemple de turbine à gaz d'aéronef susceptible d'être équipée du dispositif de production de puissance électrique selon l'invention. Sur cette figure, on a représenté la turbine à gaz 24 avec son carter compresseur 26, son carter de turbine haute pression 28, son carter de turbine libre 30 et sa tuyère de sortie 32. On a représenté également l'arbre de turbine libre 34 de ladite turbine à gaz.

Dans les modes de réalisation du dispositif de production de puissance électrique qui vont être décrits ci-après, le dispositif est monté sur ou en relation avec la tuyère 32 de sortie de la turbine à gaz. Ce dispositif pourrait éventuellement être placé sur une autre partie chaude de la turbine.

Dans le premier mode de réalisation représenté sur la figure 3, le dispositif de production de puissance électrique 40 est monté directement sur la face externe de la paroi 42 de la tuyère 32. Le dispositif de génération de puissance électrique 40 est constitué de préférence par des ensembles de cellules thermoélectriques associées entre elles pour former des ensembles annulaires 44 répartis régulièrement sur la longueur de la paroi 42 de la tuyère 32. Chaque anneau est constitué bien sûr par une suite de cellules thermoélectriques du type représenté sur la figure 1 reliées entre-elles électriquement et dans lesquelles les supports mécaniques 22 et 20 sont souples pour pouvoir conformer l'ensemble à la forme de révolution de la paroi 42 de la tuyère 32. Ainsi, la première face des éléments de conversion thermoélectriques 44 est en contact par un pont thermique avec la face externe de la paroi 42 de la tuyère 32 alors que la deuxième face des éléments de conversion thermoélectriques 44 est en contact avec l'air extérieur qui sert ainsi de source froide SF, de préférence une paroi externe 48 (munie éventuellement de perturbateurs) formant un pont thermique est prévue. La source chaude SC, comme on l'a expliqué, sont les gaz d'échappement G circulant dans la tuyère 32 réchauffant par convection la face interne de la paroi 42 de la tuyère 32.

Sur la figure 4, on a représenté une variante de réalisation du dispositif de production de puissance électrique dans laquelle la source chaude SC est toujours constituée par la paroi 42 de la tuyère 32 mais la source froide SF est constituée par la circulation d'un fluide froid F dans un espace annulaire 46 défini par une paroi interne 48 au contact des deuxièmes faces des éléments de conversion thermoélectriques 44 et par une paroi externe 50. On obtient ainsi une meilleure circulation du fluide froid et un meilleur échange thermique avec les cellules thermoélectriques 44 puisque des chicanes peuvent être prévues dans l'espace annulaire 46. En outre bien entendu, ce mode de réalisation permet d'utiliser d'autre fluide froid que l'air comme l'huile de refroidissement ou le carburant. Cependant, on peut toujours utiliser l'air extérieur ou de l'air froid prélevé dans différentes parties de la turbine à gaz.

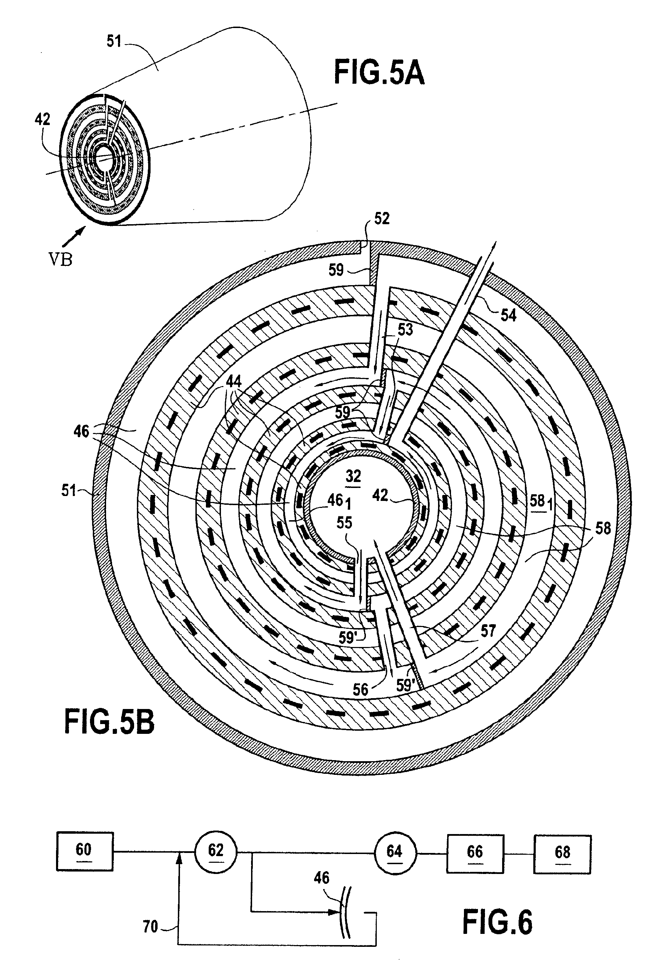

Sur les figures 5A et 5B, on a représenté un troisième mode de réalisation du dispositif de production de puissance électrique.

Sur ces figures, on retrouve la paroi 42 de la tuyère 32 qui sert de paroi intérieure et la paroi 51 qui est la paroi extérieure de la tuyère 32. Le fluide froid F (air froid, huile de refroidissement ou carburant) arrive par le ou les tubes d'arrivée 52 puis circule (dans le sens définit par convention positif) dans les zones annulaires concentriques 46 en décrivant un mouvement de spirale vers le centre de la tuyère. Des cloisons radiales étanches 59 sont disposées de telle sorte à canaliser le fluide froid F pour décrire ledit mouvement en spirale associées à des tubes 53 permettant la communication entre les zones annulaires 46. Dans la dernière zone annulaire (de plus petit rayon) 46₁, le fluide froid F est évacué vers l'extérieur au travers du ou des tubes 54.
Le fluide chaud G (gaz d'échappement de la tuyère) est prélevé au niveau des gaz d'échappement de la tuyère par le ou les tubes d'arrivée 55 puis circule (dans le sens définit par convention négatif) dans les zones annulaires 58 en décrivant un mouvement de spirale vers l'extérieur de la tuyère en partant de la zone de gaz d'échappement 32. Des cloisons étanches 59' sont disposées de telle sorte à canaliser le fluide chaud G pour décrire ledit mouvement en spirale associées à des tubes 56 permettant la communication entre les zones annulaires 58. Dans la dernière zone annulaire (de plus grand rayon) 58₁, le fluide chaud G est ramené vers l'écoulement principal des gaz d'échappement de la tuyère au travers du ou des tubes 57.
Plusieurs ensembles annulaires de cellules thermoélectriques 44 sont montés concentriquement de telles sorte à ce que l'une des faces de ces ensembles soit en contact avec le fluide froid F et l'autre face soit en contact avec le fluide chaud G. On réalise ainsi un échangeur cylindrique à contre-courant.

Sur la figure 6, on a représenté, dans le cas particulier où le fluide froid est constitué par le carburant, un mode possible d'alimentation de la zone annulaire 46 (qui peut-être constituée de plusieurs couronnes concentriques comme décrit sur le dispositif de la figure 5B) constituant la source froide du dispositif de production de puissance électrique. Sur cette figure 6, on a représenté le réservoir de carburant 60 une pompe basse pression 62 qui est reliée à une pompe haute pression 64 qui délivre le carburant sous pression à un régulateur 66 lui-même relié aux injecteurs 68 de la chambre de combustion. Un faible débit de carburant est prélevé à la sortie de la pompe basse pression 62 pour alimenter la zone annulaire 46 constituant la source froide en carburant. Après avoir circulé dans la zone annulaire 46, le carburant est réinjecté à l'entrée de la pompe basse pression 62 par la tubulure 70.

## Revendications

1. Dispositif de production de puissance électrique dans une turbine à gaz ou analogues d'un aéronef comprenant une pluralité de cellules thermoélectriques (44) dont une face entoure une source chaude (SC), la source froide (SF) étant constituée par une circulation d'un fluide froid (F) réalisée sur l'autre face desdits cellules thermoélectriques, dispositif dans lequel ladite source froide (SF) est constituée par au moins une zone annulaire (46) dans laquelle est introduit ledit fluide froid, une paroi (48) de ladite zone annulaire formant un pont thermique avec la deuxième face desdites cellules thermoélectriques, la deuxième paroi de la zone annulaire (46) étant l'enveloppe extérieure du dispositif, ledit dispositif étant **caractérisé en ce que** la source chaude est constituée par au moins une zone annulaire (58) dans laquelle s'écoule une partie des gaz d'échappement (constituant le fluide chaud) selon un mouvement en spirale vers les rayons extérieurs ; **en ce que** la source froide est constituée par ladite au moins une zone annulaire (46) dans laquelle s'écoule le fluide froid (F) selon un mouvement en spirale vers les rayons intérieurs, et **en ce que** au moins un ensemble annulaire de cellules thermoélectriques (44) est monté concentriquement de sorte que l'une des faces de cet ensemble soit en contact avec le fluide froid (F) et que l'autre face soit en contact avec le fluide chaud, par quoi on réalise ainsi un échangeur cylindrique à contre-courant.

2. Dispositif de production de puissance électrique selon la revendication 1, **caractérisé en ce que** ledit fluide froid (F) est choisi dans le groupe comprenant le carburant de ladite turbine, l'huile de refroidissement ou de lubrification, l'air prélevé au niveau des compresseurs de ladite turbine, l'air de refroidissement du compartiment moteur et l'air extérieur à ladite turbine.

3. Dispositif selon l'une quelconque des revendications 1 et 2, **caractérisé en ce que** ladite source chaude (SC) est constituée par la paroi (42) de la tuyère (32) de ladite turbine réchauffée par convection par les gaz d'échappement.

4. Dispositif selon l'une quelconque des revendications 1 à 3, **caractérisé en ce qu'**il comprend une pluralité de zones annulaires (58) reliées entre elles dans lesquelles s'écoule une partie des gaz d'échappement, une pluralité de zones annulaires (46) reliées entre elles dans lesquelles s'écoule le fluide froid, et une pluralité d'ensembles annulaires (44) de cellules thermoélectriques, chaque ensemble annulaire étant disposé entre une zone annulaire (58) pour les gaz d'échappement et une zone annulaire (46) pour le fluide froid (F).

5. Utilisation du dispositif de production de puissance électrique selon l'une quelconque des revendications 1 à 4 pour l'alimentation d'accessoires de la turbine à gaz en électricité.

6. Turbomoteur d'hélicoptère comportant un dispositif de production de puissance électrique selon l'une quelconque des revendications 1 à 4.

## Claims

1. A device for producing electrical power in a gas turbine or the like of an aircraft, the device comprising a plurality of thermoelectric cells (44) having one face surrounding a hot source (SC), the cold source (SF) being constituted by a cold fluid (F) flowing over the other face of said thermoelectric cells, in which device said cold source (SF) is constituted by at least one annular zone (46) into which said cold fluid is introduced, a wall (48) of said annular zone forming a thermal bridge with the second faces of said thermoelectric cells, the second wall of the annular zone (46) being the outer envelope of the device, said device being **characterized in that** the hot source is constituted by at least one annular zone (58) in which there flows a fraction of the exhaust gas (constituting the hot source) with a spiral movement towards the outer radii; **in that** the cold source is constituted by said at least one annular zone (46) in which there follows the cold fluid (F) with a spiral movement towards the inner radii; and **in that** at least one annular assembly of thermoelectric cells (44) is mounted concentrically so that one of the faces of the assembly is in contact with the cold fluid (F) and the other face is in contact with the hot fluid, thereby providing a counterflow cylindrical heat exchanger.

2. An electrical power production device according to claim 1, **characterized in that** said cold fluid (F) is selected from the group comprising: fuel for said turbine; cooling or lubrication oil; air taken from the compressors of said turbine; air for cooling the engine compartment; and air outside said turbine.

3. A device according to claim 1 or claim 2, **characterized in that** said hot source (SC) is constituted by the wall (42) of the nozzle (32) of said turbine heated by convection by the exhaust gases.

4. A device according to any one of claims 1 to 3, **characterized in that** it includes a plurality of interconnected annular zones (58) in which there flows a fraction of the exhaust gas, a plurality of interconnected annular zones (46) in which there flows the cold fluid, and a plurality of annular assemblies (44) of thermoelectric cells, each annular assembly being disposed between an annular zone (58) for the exhaust gas and an annular zone (46) for the cold fluid (F).

5. The use of a device for producing electrical power in accordance with any one of claims 1 to 4 for electrically powering accessories of the gas turbine.

6. A helicopter turbine engine including an electrical power production device according to any one of claims 1 to 4.

## Patentansprüche

1. Vorrichtung zur Erzeugung von elektrischer Leistung in einer Gasturbine oder ähnlichem eines Luftfahrzeugs, umfassend eine Vielzahl von thermoelektrischen Zellen (44), deren eine Seite eine heiße Quelle (SC) umschließt, wobei die kalte Quelle (SF) durch einen Kreislauf eines kalten Fluids (F) gebildet ist, der auf der anderen Seite der thermoelektrischen Zellen realisiert ist, Vorrichtung, bei der die kalte Quelle (SF) durch wenigstens einen ringförmigen Bereich (46) gebildet ist, in den das kalte Fluid eingeleitet wird, wobei eine Wand (48) des ringförmigen Bereichs eine Wärmebrücke mit der zweiten Seite der thermoelektrischen Zellen bildet, wobei die zweite Wand des ringförmigen Bereichs (46) der Außenmantel der Vorrichtung ist, wobei die Vorrichtung **dadurch gekennzeichnet ist, daß** die heiße Quelle durch wenigstens einen ringförmigen Bereich (58) gebildet ist, in dem ein Teil der Abgase (die das heiße Fluid bilden) in einer spiralförmigen Bewegung in Richtung der Außenradien strömt, daß die kalte Quelle durch den wenigstens einen ringförmigen Bereich (46) gebildet ist, in dem das kalte Fluid (F) in einer spiralförmigen Bewegung in Richtung der Innenradien strömt, und daß wenigstens eine ringförmige Anordnung von thermoelektrischen Zellen (44) konzentrisch angebracht ist, so daß die eine der Seiten dieser Anordnung mit dem kalten Fluid (F) in Kontakt ist und die andere Seite mit dem heißen Fluid in Kontakt ist, wodurch ein zylindrischer Gegenstromtauscher ausgebildet wird.

2. Vorrichtung zur Erzeugung von elektrischer Leistung nach Anspruch 1, **dadurch gekennzeichnet, daß** das kalte Fluid (F) aus der Gruppe umfassend den Treibstoff der Turbine, das Kühl- oder Schmieröl, die im Bereich der Verdichter der Turbine entnommene Luft, die Kühlluft des Triebwerksraums und die Luft außerhalb der Turbine ausgewählt ist.

3. Vorrichtung nach einem der Ansprüche 1 und 2, **dadurch gekennzeichnet, daß** die heiße Quelle (SC) durch die Wand (42) der Düse (32) der Turbine gebildet ist, die mittels Konvektion durch die Abgase erhitzt wird.

4. Vorrichtung nach einem der Ansprüche 1 bis 3, **dadurch gekennzeichnet, daß** sie eine Vielzahl von untereinander verbundenen ringförmigen Bereichen (58), in denen ein Teil der Abgase strömt, eine Vielzahl von untereinander verbundenen ringförmigen Bereichen (46), in denen das kalte Fluid strömt, sowie eine Vielzahl von ringförmigen Anordnungen (44) von thermoelektrischen Zellen umfaßt, wobei jede ringförmige Anordnung zwischen einem ringförmigen Bereich (58) für die Abgase und einem ringförmigen Bereich (46) für das kalte Fluid (F) angeordnet ist.

5. Verwendung der Vorrichtung zur Erzeugung von elektrischer Leistung nach einem der Ansprüche 1 bis 4, für die Elektrizitätsversorgung von Zusatzeinrichtungen der Gasturbine.

6. Turbomotor eines Hubschraubers, der eine Vorrichtung zur Erzeugung von elektrischer Leistung nach einem der Ansprüche 1 bis 4 umfaßt.
